# EUROPEAN PATENT APPLICATION

(11) **EP 0 849 041 A2**
(43) Date of publication of application: **24.06.1998**
(21) Application number: 97310392.2
(22) Date of filing: 19.12.1997
(51) Int. Cl.: B24B 37/04, H01L 21/304, B24B 49/14, B24B 55/02

(54) **Polishing method**

(30) Priority: 19.12.1996 US 33678 P
(71) Applicant: TEXAS INSTRUMENTS INCORPORATED, Dallas Texas 75265 (US)
(72) Inventor: Bawa, Mohendra S., Plano, Texas (US); Simpson, Vikki Sue, Sherman, Texas (US); Grimes, Michael H., Plano, Texas (US); Allen, Franklin Louis, Sherman, Texas (US); L'Anglois, Kenneth John, Sherman, Texas (US); Miller, Palmer Arthur, Sherman, Texas (US); Etheridge, Gary Lee, Sherman, Texas (US)
(74) Representative: Darby, David Thomas

(57) **Abstract**

A method for controlling the temperature of a polishing slurry during chemical-mechanical polishing, the method comprising circulating the polishing slurry (28) in a chemical-mechanical polishing apparatus (10), monitoring the temperature of the polishing slurry, exposing the slurry to a temperature control element (36) during the recirculation of the polishing slurry to adjust the temperature of the polishing slurry and maintaining the temperature of the polishing slurry within a predetermined range, thereby maintaining control of the temperature of the polishing slurry.

## Description

### Technical Field of the Invention

This invention relates, in general, to a method for promoting the isothermal polishing of silicon wafers during chemical-mechanical polishing and, in particular to, monitoring and controlling the temperature of the siliceous chemical-mechanical silicon polishing slurry to maintain the slurry at a constant temperature during the silicon polishing process.

### Background of the Invention

Without limiting the scope of the invention, its background is described in connection with polishing a semiconductor wafer, as an example.

Heretofore, in this field, chemical-mechanical polishing of silicon wafers has been performed at various stages of device fabrication for planarizing irregular top surface topography. For example, in the process for fabricating modern semiconductor integrated circuits, it is necessary to form conductive lines of other structures above previously formed structures. Prior structure formation, however, often leaves the top surface topography of the silicon wafer highly irregular. As a result of these irregularities, deposition of subsequent layers of material could easily result in incomplete coverage, breaks in the deposited material, or voids if it were deposited directly over the aforementioned highly irregular surfaces. If the irregularities are not alleviated at each major processing step, the top surface topography of the face irregularities will tend to become even more irregular, causing further problems as the layers stack up in the further processing of the semiconductor structure.

Depending upon the type of material used and their intended purposes, numerous undesirable characteristics are produced when these deposition irregularities occur. Incomplete coverage of an insulating oxide layer can lead to short circuits between metalization layers. Likewise, voids can trap air or processing gases, either contaminating further processing steps, or simply lowering overall device reliability. Sharp points on conductors can result in unusual, undesirable field effects. One problem that is widely recognized in the wafer manufacturing process is that, in general, processing high density circuits over highly irregular structures can lead to very poor yields and device performance.

Consequently, it is desirable to affect some type of planarization or flattening of integrated circuit structures in order to facilitate the processing of multi-layer integrated circuits and to improve their yield, performance, and reliability. In fact, all of today's high-density integrated circuit fabrication techniques make use of some method of forming planarized structures at critical points in the fabrication process.

Conventionally, the polishing apparatus used to planarize a semiconductor wafer has a turntable, often referred to as a rotating platen, and a top ring that exerts a constant pressure on the turntable. A polishing pad -is typically attached to the upper surface of the turntable. The semiconductor wafer to be polished, is placed on the polishing pad and clamped between the top ring and the turntable. The semiconductor wafer is securably fixed to the lower surface of the top ring by wax, a pad or via suction so that the semiconductor wafer can be rotated integrally with the top ring during polishing.

While the turntable is rotated, a metered stream of slurry from a slurry supply is delivered to the upper surface of the polishing pad. Typically, the slurry is a liquid comprising chemicals and an abrasive. For example, slurry chemistry generally consists of a basic solution having a pH of about 11. This alkaline polishing slurry may also contain fine polishing particles such as colloidal silica (SiO₂).

As the demand for faster and more powerful semiconductors containing integrated circuits rises, the semiconductor industry must supply integrated circuits having smaller and smaller wiring patterns. These smaller wiring patterns are interconnected within narrower spaces, requiring improved methods for planarizing the irregular surface topography of silicon wafers. Several parameters have been discovered that affect the quality of chemical-mechanical polishing of silicon wafers. Specifically, mechanical factors such as pressure exerted by the top ring on the turntable and the platen speed as well as chemical factors including the type of slurry used, slurry pH, slurry additives, slurry temperature, slurry dilution ratio, and slurry volume. Each of the mechanical and chemical factors contribute to the quality of the planarized surface on the silicon wafer, which concomitantly affects the yield, at each step, of semiconductor integrated circuit process.

More specifically, it has been discovered that the quality of the finish during the planarization process is directly related to the temperature of the slurry. Therefore, what is needed is a method to promote the isothermal polishing of silicon wafers during the chemical-mechanical polishing process. Improved methods of chemical-mechanical polishing will increase the slurry life, resulting in greater recirculation of the silicon polishing slurry. A longer slurry life results in both a cost savings from the decreased use of slurry batches, as well as a reduced environmental impact from the discarded volumes of polishing slurry.

### Summary of the Invention

The present invention disclosed herein, comprises promoting the isothermal polishing of silicon wafers during chemical-mechanical polishing by monitoring and controlling the temperature of the siliceous chemical-mechanical silicon polishing slurry to maintain the slurry at a constant temperature during the silicon polishing process. The method provides for recycling and reusing the polishing slurry so that the polishing slurry is not discarded after each production cycle.

The method of the present invention comprises recirculating a polish slurry in a chemical-mechanical wafer polishing apparatus and monitoring the temperature of the polishing slurry at one or more points in the recirculation process. The slurry temperature is maintained by exposing the polishing slurry to either heating or cooling elements or both.

The mechanism that determines the relative heating and cooling effect on the polishing slurry responds to the input temperature from the temperature probe or probes disposed to read slurry temperature. The location of a temperature probe may depend on the desired input that serves to control the heating and cooling elements. The temperature control mechanism may be via a direct connection between the temperature probe or probes and the heating and cooling elements. Alternatively, a controller may be disposed between the temperature probe or probes to control the relative heating and cooling of the polish slurry. The controller is responsive to a user-defined input, for example, a specific temperature or temperature range for the polish slurry.

It may be desirable to have more than one probe along the polishing slurry recirculation system. For example, a temperature probe may be located at the beginning and at the end of the slurry recirculation cycle. Specifically, the slurry temperature may be measured with an in-line temperature probe installed as close as possible to the heating and cooling elements, since the polishing slurry will dissipate heat by convection to the environmental air and to the recirculation plumbing. The exit temperature of the slurry from the heating and cooling elements may also be measured to ensure optimum slurry temperature is maintained.

During the polishing process, there is an increase in slurry temperature due to friction along with a release of silicon oxide particles which affect pH and the silica to alkali ratio. To attain greater control of the polishing process, the present invention helps semiconductor wafer producers to limit the number of variables that affect wafer quality and yield, by allowing the polishing unit operator to closely monitor and control the polishing slurry temperature throughout the polishing process. For example, the controller may want to maintain slurry temperature constant throughout the polishing run. Alternatively, the operator may want to rapidly or slowly ramp slurry temperature either up or down during the polishing process to address changes in slurry pH, composition, or because the wafer being polished has special temperature and friction requirements. An alternative to the ramping method, is using the present invention to control the polishing slurry temperature in discrete steps at different stages of the polishing process. The operator may also want to vary temperature according to the number of times that a polishing slurry has already been used. As a final example, the operator may want to vary the temperature depending on the dilution, if any, of the polishing slurry.

These and other features of the invention that will be apparent to those skilled in the art from the following detailed description of the invention, taken together with the accompanying drawings.

### Description of the Drawings

In the drawings:
Figure 1A is a simplified illustration of a wafer polishing apparatus with a temperature control unit;
Figure 1B is a simplified illustration of a polishing wafer apparatus having a temperature control unit;
Figure 2 is an illustration of a temperature control unit; and
Figure 3 is an illustration of a temperature control unit.

Corresponding numerals and symbols in different figures refer to corresponding parts unless otherwise specified.

### Detailed Description of the Invention

While the making and using of various embodiments of the present invention are discussed in detail below, it should be appreciated that the present invention provides many applicable inventive concepts which can be embodied in a wide variety of specific contexts. The specific embodiments discussed herein are merely illustrative of specific ways to make and use the invention and do not delimit the scope of the invention.

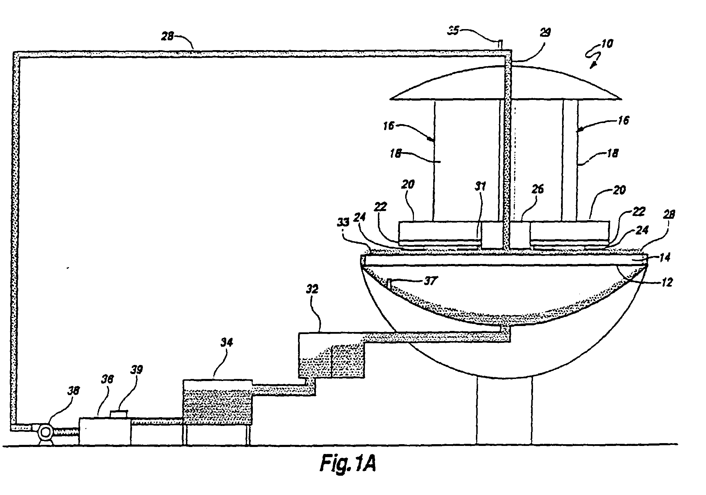

In Figure 1A, a typical apparatus for chemical-mechanical polishing of various workpieces, such as semiconductor wafers, is generally depicted as 10. The polishing apparatus 10 includes a lower platen 12 having a polishing pad 14 attached thereto on the upper surface of the lower platen 12. The polishing apparatus 10 may include a plurality of polishing units 16. Each polishing unit 16 includes a shaft 18, an upper platen 20, and a carrier plate 22. Each polishing unit 16 holds at least one semiconductor wafer 24.

In operation, the lower platen 12 and the polishing unit 16 are counter rotated such that the lower surface of the semiconductor wafers 24 contacts the upper surface of the polishing pad 14. The polishing units 16 are rotated by the friction generated between the polished surface of semiconductor wafers 24 and polishing pad 14. The lower platen 12 and the upper platens 20 both rotate counterclockwise while the center drive 26 rotates clockwise while evenly distributed slurry 28 across polishing pad 14 through a circular gap between center drive 26 and polishing pad 14. The slurry 28 provides for both chemical and mechanical polishing of the silicon wafers 24.

The temperature of the polishing slurry 28 is varied in a temperature control chamber 36. The necessity for, and the amount of, cooling and heating of the slurry 28 in the temperature control chamber 36 may be determined from slurry temperature samples taken at one or more strategic locations throughout the circulation path of the slurry 28. For example, the temperature may be tested proximate to the center drive 26 at point 31, in the defoaming chamber 32 or upstream of the temperature control chamber 36 by temperature probes 37 or 41. After the slurry 28 passes through the temperature control chamber 36, a pump 38 circulates the slurry 28 back to the surface of the polishing pad 14.

In one embodiment of the present invention the temperature controller chamber 36 receives the input from one or more temperature probes 35, 37 or 41 located to sample slurry temperature. Slurry temperature may be samples in intervals, or may be monitored continuously. The output from the probes 35, 37 and 41 may be directed to a controller 39 on the temperature controlled chamber 36, that may also be used by the operator to preset the inlet slurry temperature during a polishing run. In operation, a user-defined temperature is set before the polishing run to, for example, pre-heat the slurry. The temperature set by the operator may also vary throughout the polishing run between about 17 and 70 degrees Celsius, depending on the specific needs of the wafer.

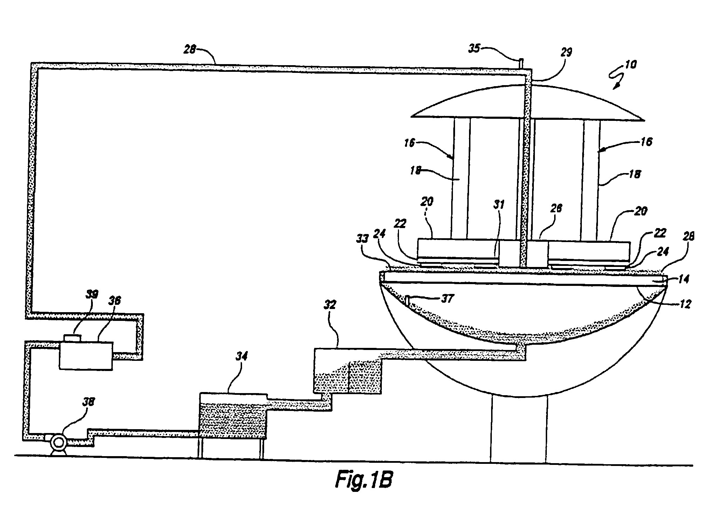

Figure 1B shows an alternative placement for the temperature control chamber 36. In Figure 1B, the temperature control chamber 36 is located in the slurry 28 recirculation path at a point downstream of the pump 38. Temperature control chamber 36 controls the temperature of the slurry 28 during the polishing process. Temperature measurements of the slurry 28 may be taken in a variety of locations such as at point 29, 31 or 33. Similarly, temperature measurements from a variety of locations may be automatically relayed to controller 39 of temperature control chamber 36 from probes 35, 37 or 41. It should be noted by one skilled in the art, that the location, number, and method of temperature measurement is not critical to the present invention, so long as accurate slurry 28 temperature measurements are provided to temperature control chamber 36, such that the slurry 28 temperature is adequately controlled in the temperature control chamber 36.

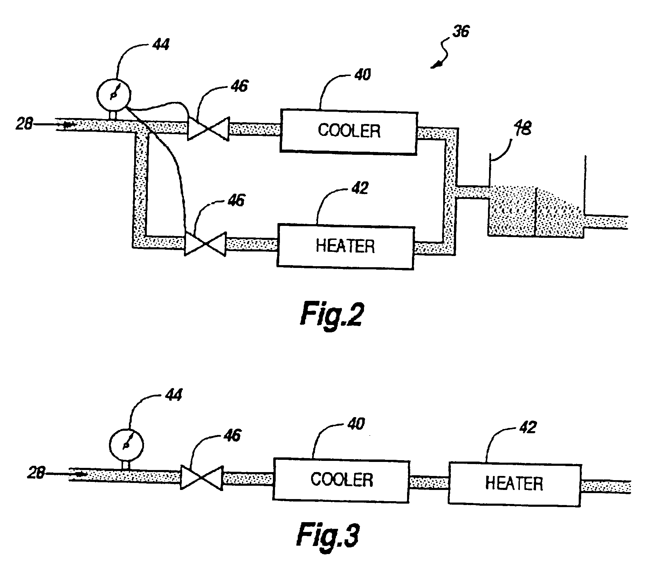

Figure 2 shows one embodiment of the temperature control chamber 36. A slurry chiller 40 is located in parallel with a slurry heater 42. In one embodiment of the present invention, the slurry chiller 40 and the slurry heater 42 may each be shell and tube heat exchangers. In this embodiment, the slurry 28 does not come in contact with the cooling or heat medium. In another embodiment of the present invention, the slurry chiller 40 may be a serpentine chiller that comes in contact with the slurry 28. In this embodiment, the slurry heater 42 may also be a serpentine heater that is disposed alongside or within the serpentine chiller, wherein slurry 28 comes in contact with the element of the slurry chiller 40 and the element of the slurry heater 42 almost concurrently.

Either upstream or downstream from the slurry heater 42 and the slurry chiller 40, are one or more temperature controlled solenoids 46, that serve to open slurry 28 flow into either the slurry chiller 40, the slurry heater 42, or both. The temperature control solenoids 46 are controlled by a temperature sensing unit 44. Those of skill in the art will recognize that alternative embodiments of the present invention can locate the temperature sensing unit 44 either before or after the temperature control chamber 36. In fact, more than one temperature sensing unit 44 may be used to control the temperature controlled solenoids 46. Also, the temperature controlled solenoids 46 may be placed before or after the slurry chiller 40 and the slurry heater 42. A mixing chamber 48 may be located downstream of the slurry chiller 40 and the slurry heater 42 to allow the slurry 28 to reach a uniform temperature prior to recirculation.

As depicted in Figure 3, the slurry chiller 40 and the slurry heater 42 may be located in series. In this embodiment, one temperature controlled solenoid 46 is required to control slurry 28 flow. Again, the temperature controlled solenoid 46 can be either before or after the slurry chiller 40 and slurry heater 42. Furthermore, the slurry chiller 40 and the slurry heater 42 can even form part of a single unit. For example, the serpentine chiller 40 can be intertwined with either a serpentine heater 42, or by locating a heater 42 alongside the chiller 40.

In operation, the present invention improves existing temperature control systems used during chemical-mechanical processing. Typically, during polishing, the temperature of the wafer rises because the mechanical heat production caused by friction. Most of the heat is removed during the recirculating of slurry 28 through the recirculation system. The temperature of the polishing pad 14 is usually monitored and used to adjust polishing pressure and slurry flow.

Alone, this approach to controlling wafer temperature has failed to achieve the desired temperature uniformity. That is because the change in applied pressure and slurry flowrate addresses heating at the macroscale. Macroscale changes, such as adjustment of the slurry flow may result in major fluctuations of the slurry composition and of the polish reactants. Unfortunately, these wafer cooling mechanisms fail to address wafer cooling at the microscale.

The use of the temperature control chamber 36 of the present invention to control and maintain the slurry 28 temperature directly addresses the microscale changes in wafer temperature. In addition, the use of the temperature control chamber 36 of the present invention minimizes or removes the temperature variable from the wafer polishing process. For example, maintaining a constant temperature will allow a more constant silicon polish rate which, in turn, improves surface quality. Similarly, as the temperature control chamber 36 of the present invention controls the temperature of the polishing slurry 28, the control of the silica to alkali ratio which prevents coagulation, settling out, gelling and precipitation of slurry components is more readily controllable. Further, the use of the temperature control chamber 36 of the present invention minimizes the need to fluctuate the polishing slurry 28 flow rate which, in turn, minimizes fluctuations in polishing rate, surface quality and yield. The present invention, therefore, synergistically improves the surface quality and yield of the chemical-mechanical polishing of silicon wafers. Specifically, the use of the temperature control chamber 36 of the present invention to control slurry temperature also enhances the precision of the control over slurry pH and slurry flow rate.

While this invention has been described with reference to illustrative embodiments, this description is not intended to be construed in a limiting sense. Various modifications and combinations of the illustrative embodiments as well as other embodiments of the invention, will be apparent to those of skill in the art upon reference to the description. It is, therefore, intended that the appended claims encompass any such modifications or embodiments.

## Claims

1. A method for maintaining the temperature of a polishing slurry during chemical-mechanical wafer polishing, the method comprising:
circulating a polishing slurry in a chemical-mechanical wafer polishing apparatus;
monitoring the temperature of the polishing slurry;
exposing the polishing slurry to a temperature control element to adjust the temperature of the polishing slurry; and
maintaining the temperature of the polishing slurry within a predetermined range thereby controlling the temperature of the polishing slurry.

2. The method of claim 1 wherein the step of exposing the polishing slurry to the temperature control element to adjust the temperature of the polishing slurry increases the temperature of the polishing slurry.

3. The method of claim 1 wherein the step of exposing the polishing slurry to the temperature control element to adjust the temperature of the polishing slurry decreases the temperature of the polishing slurry.

4. The method of claim 1 wherein the step of exposing the polishing slurry to a temperature control element to adjust the temperature of the polishing slurry stabilizes the temperature of the polishing slurry.

5. The method of claim 1 wherein the step of maintaining the temperature of the polishing slurry within a predetermined range comprises maintaining the temperature of the polishing slurry between about 17 and 70 degrees Celsius.

6. The method of claim 1 wherein the step of maintaining the temperature of the polishing slurry within a predetermined range comprises maintaining the temperature of the polishing slurry at about 25 degrees Celsius.

7. The method of claim 1 further comprising the step of monitoring the temperature of the polishing slurry at a plurality of locations along the chemical-mechanical polishing apparatus.

8. The method of claim 1 further comprising the step of varying the temperature of the polishing slurry during the polishing process in discrete steps.

9. The method of claim 1 further comprising the step of varying the temperature of the polishing slurry by ramping up the temperature of the polishing slurry to a running temperature between about 17 and 70 degrees Celsius.

10. A method for maintaining the temperature of a polishing slurry during chemical-mechanical wafer polishing, the method comprising:
circulating a polishing slurry in a chemical-mechanical wafer polishing apparatus;
monitoring the temperature of the polishing slurry;
exposing the polishing slurry to a temperature control element to adjust the temperature of the polishing slurry; and
maintaining the temperature of the polishing slurry between about 17 and 70 degrees Celsius thereby controlling the temperature of the polishing slurry.

11. The method of claim 10 wherein the step of exposing the polishing slurry to the temperature control element to adjust the temperature of the polishing slurry increases the temperature of the polishing slurry.

12. The method of claim 10 wherein the step of exposing the polishing slurry to the temperature control element to adjust the temperature of the polishing slurry decreases the temperature of the polishing slurry.

13. The method of claim 10 wherein the step of exposing the polishing slurry to the temperature control element to adjust the temperature of the polishing slurry stabilizes the temperature of the polishing slurry.

14. The method of claim 10 further comprising the step of monitoring the temperature of the polishing slurry at a plurality of locations along the chemical-mechanical polishing apparatus.

15. The method of claim 10 further comprising the step of varying the temperature of the polishing slurry during the polishing process in discrete steps.

16. A method for maintaining the temperature of a polishing slurry during chemical-mechanical wafer polishing, the method comprising:
circulating a polishing slurry in a chemical-mechanical wafer polishing apparatus;
monitoring the temperature of the polishing slurry;
exposing a first volume of the polishing slurry to a cooling element;
exposing a second volume of the polishing slurry to a heating element;
combining the first volume with the second volume to adjust the temperature of the polishing slurry; and
maintaining the temperature of the polishing slurry within a predetermined range thereby controlling the temperature of the polishing slurry.

17. The method of claim 16 wherein the step of combining the first volume with the second volume further comprises, mixing the first volume with the second volume, thereby providing for uniformity in the temperature of the polishing slurry.

18. The method of claim 16 wherein the step of maintaining the temperature of the polishing slurry within a predetermined range comprises maintaining the temperature of the polishing slurry between about 17 and 70 degrees Celsius.

19. The method of claim 16 wherein the step of maintaining the temperature of the polishing slurry within a predetermined range comprises maintaining the temperature of the polishing slurry at about 25 degrees Celsius.

20. The method of claim 16 further comprising the step of monitoring the temperature of the polishing slurry at a plurality of locations along the chemical-mechanical polishing apparatus.
